# EUROPEAN PATENT APPLICATION

(11) **EP 4 768 355 A1**
(43) Date of publication of application: **01.07.2026**
(21) Application number: 25217569.0
(22) Date of filing: 21.11.2025
(51) Int. Cl.: B60W 40/00, B60W 50/00, G06N 3/08, G06V 20/56, G06V 20/59, G06N 20/00

(54) **SCENARIO GENERATION SYSTEM AND METHOD FOR STATE OR SITUATION OF VEHICLE OR USER**

(30) Priority: 27.12.2024 JP 2024232871
(71) Applicant: Toyota Jidosha Kabushiki Kaisha, Toyota-shi, Aichi-ken 471-8571 (JP)
(72) Inventor: FUKUSHIMA, Shintaro, Toyota-shi 471-8571 (JP); YAMAURA, Yusuke, Toyota-shi 471-8571 (JP)
(74) Representative: TBK

(57) **Abstract**

A scenario generation system includes: a scenario estimation unit (211) configured to integrate, by machine learning, a plurality of types of input data affecting a state or situation of a vehicle (100) or user, to estimate a scenario of the state or situation, and configured to, when at least one type of data among the input data is data acquired at non-uniform frequencies or intervals and not time-synchronized, estimate a scenario for any given time point of the at least one type of data; and a machine learning model update unit (212) configured to update a model of the machine learning.

## Description

### BACKGROUND OF THE INVENTION

### 1. Field of the Invention

The present invention relates to the technical field of scenario generation systems that generate a scenario of either or both of a state and a situation (herein referred to as "state or situation") in which either or both of a vehicle and a user (herein referred to as "vehicle or user") are placed. More particularly, the present invention relates to the technical field of scenario generation systems that generate a scenario of a state or situation in which a vehicle or user is placed using data acquired at either or both of non-uniform frequencies and intervals (herein referred to as "frequencies or intervals").

### 2. Description of Related Art

As technologies related to this type of system, for example, a driver state estimation device, a driver state estimation program, a daily operation report generation method, and a daily operation report, all directed to inattentive driving by a vehicle user or driver, particularly technologies for detecting the state of a user operating a vehicle, have been proposed (see Japanese Unexamined Patent Application Publication No. 2022-74441 (JP 2022-74441 A)). In addition, for example, a driver state estimation device that can accurately estimate a driver's drowsiness level has been proposed (see Japanese Unexamined Patent Application Publication No. 2021-96784 (JP 2021-96784 A)).

### SUMMARY OF THE INVENTION

However, with the above background art, it is not possible to estimate the state or situation in which a vehicle or user is placed from data acquired at non-uniform frequencies or intervals. Even if such estimation is attempted, the estimation method of the state or situation needs to be revised and accurate estimation is not easily achieved. In addition, with the above background art, it is difficult or even impossible to integrate multiple states.

An object of the present invention is to provide a scenario generation system that can generate, even from input data acquired at non-uniform frequencies or intervals, a scenario integrating multiple states or situations in which a vehicle or user is placed.

In order to achieve the above object, a scenario generation system according to the present invention is configured to generate a scenario of a state or situation of a vehicle or user. The scenario generation system includes: a scenario estimation unit configured to integrate, by machine learning, a plurality of types of input data affecting a state or situation of a vehicle or user, to estimate a scenario of the state or situation, and configured to, when at least one type of data among the input data is data acquired at non-uniform frequencies or intervals and not time-synchronized, estimate a scenario for any given time point of the at least one type of data; a probability estimation unit configured to estimate the probability of the estimated scenario; a predicted value estimation unit configured to estimate, for the at least one type of data, predicted value data that is not acquired at the time of scenario estimation; and a machine learning model update unit configured to update a model of the machine learning based on the estimated predicted value data, actual measured values corresponding to the estimated predicted value data among the input data, the estimated probabilities, and the input data.

According to one aspect of the scenario generation system of the present invention, the scenario generation system uses the scenario estimated by the scenario estimation unit for the input data acquired at non-uniform frequencies or intervals and not time-synchronized, the probability of the scenario estimated by the probability estimation unit, and the predicted value data estimated by the predicted value estimation unit. Therefore, a scenario integrating multiple states and conditions in which the vehicle or user is placed can be generated even from input data acquired at non-uniform frequencies or intervals.

Such advantageous effects of the present invention will become more apparent from the embodiments of the invention described below.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a block diagram showing the overall configuration of a scenario generation system according to an embodiment;
FIG. 2 is a schematic conceptual diagram illustrating scenario generation and updating of a scenario estimation method in the scenario generation system according to the embodiment; and
FIG. 3 is a flowchart showing an example of processing in the scenario generation system according to the embodiment.

### DETAILED DESCRIPTION OF EMBODIMENTS

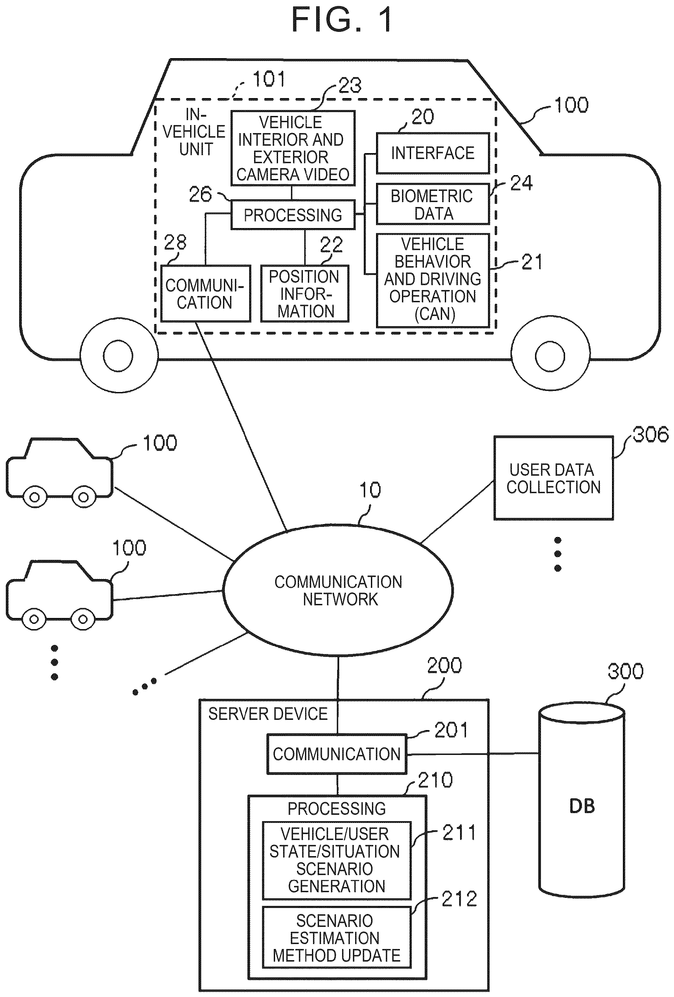

First, the overall configuration of a system that generates a scenario of a state or situation in which a vehicle or user is placed (hereinafter simply referred to as "scenario generation system") according to an embodiment will be described with reference to FIG. 1.

In the present embodiment, as will be described in detail below, the scenario generation system generates a scenario of a state or situation in which a vehicle or user is placed. Even when data acquired at non-uniform frequencies or intervals and not time-synchronized is input to the system, the system estimates a scenario for any given time point by machine learning, and at the same time, predicts or estimates data not acquired at the time of scenario estimation. Furthermore, the system updates the scenario estimation method based on these predicted values and their corresponding actual measured values, the probabilities of the estimated scenarios, and the observed data.

Not only conventional AI learning systems such as supervised learning, unsupervised learning, or reinforcement learning, but also new technologies of generative AI or large language models (LLMs) (i.e., single-modal LLMs or multimodal LLMs) that have recently been put into practical use, are currently under development, or will be developed in the future, can be adopted as the "machine learning" in the present embodiment. For example, the AI learning or LLM learning in the present embodiment may be configured using a neural network that performs efficient learning such as representation learning, transfer learning, feature selection, fine tuning or hyperparameter tuning, or ensemble learning.

As shown in FIG. 1, the scenario generation system according to the present embodiment includes an in-vehicle unit 101 mounted on a vehicle 100 and a server device 200. The in-vehicle unit 101 and the server device 200 are accommodated in a communication network 10 such as the Internet or a dedicated network line. A plurality or large number of other vehicles 100 are also accommodated in the communication network 10.

A user data collection unit 306 that collects data unique to the driver or user of the vehicle 100 (i.e., "user data") is also accommodated in the communication network 10. In addition, a general knowledge collection unit (not shown) may be accommodated in the communication network 10. This unit collects "general knowledge" that is useful when performing inference based on verbalized or textual data using a large language model (LLM) or a multimodal LLM adopted as machine learning. A map data collection unit (not shown) may also be accommodated in the communication network 10. This unit collects road maps, multipurpose maps, etc. that are useful when performing inference based on data on the state or situation related to traveling of the vehicle 100. Furthermore, an external knowledge collection unit (not shown) may also be accommodated in the communication network 10. This unit collects information that is obtained outside the vehicle 100 and that can be used in the scenario generation system to perform fine-tuning or hyperparameter tuning to incorporate domain knowledge. This information is referred to as "external related knowledge."

The user data collection unit 306, the general knowledge collection unit, and the map data collection unit may be provided at least partially in the server device 200 or in a facility in which the server device 200 is installed, or may be provided in the in-vehicle unit 101 or in the vehicle 100.

A database (DB) 300 is connected to the server device 200. The DB 300 stores various types of data including data used in the scenario generation system. The DB 300 may be connected to the server device 200 or the in-vehicle unit 101 via the communication network 10. The server device 200 includes various computer-based devices or computer devices that perform centralized or distributed processing. In other words, the scenario generation system is constructed as a system that performs centralized or distributed processing using large-scale data stored in the DB 300.

In FIG. 1, the vehicle 100 may be, for example, a hybrid electric vehicle (HEV), a plug-in HEV (PHEV), a fuel cell EV (FCEV), or a battery electric vehicle (BEV) or may be a vehicle using an internal combustion engine as the main power source, but is constructed as a connected car.

The in-vehicle unit 101 includes an interface unit 20, a vehicle behavior and driving operation (CAN) unit 21, a position information unit 22, a vehicle interior and exterior camera video unit 23, a biometric data unit 24, a processing unit 26, and a communication unit 28.

The interface unit 20 is configured to enable interaction with the driver or user inside the vehicle by voice and image. For example, when using functions provided in the vehicle 100 such as navigation functions, audiovisual (AV) functions, or autonomous driving functions, the interface unit 20 allows interaction through voice input or predetermined operations on the screen. These functions may be executed entirely or partially by the processing unit 26, or may be executed partly or entirely by a processing unit 210 of the server device 200 (in other words, the in-vehicle unit 101 may mainly serve as a browser). The interface unit 20 is also configured to output, in the form of voice and image, data supplied by the server device 200 that indicates estimation results obtained by machine learning.

The vehicle behavior and driving operation (CAN) unit 21 includes various sensors such as a vehicle speed sensor, an acceleration sensor, a distance sensor, an engine speed sensor, a temperature sensor, an altitude sensor, a pressure sensor, and a battery level sensor, each disposed at a predetermined position in the vehicle 100. The vehicle behavior and driving operation (CAN) unit 21 is configured to, under the control of the processing unit 26, transmit Controller Area Network (CAN) data related to the current traveling state of the vehicle 100 from the communication unit 28 via the communication network 10 to the server device 200 as appropriate.

The position information unit 22 includes a Global Positioning System (GPS) device, a dead reckoning unit, etc. and detects the current position of the vehicle 100. The position information unit 22 is further configured to, under the control of the processing unit 26, generate raw position information data indicating, for example, latitude and longitude or coordinates, and transmit it from the communication unit 28 via the communication network 10 to the server device 200 as appropriate.

The vehicle interior and exterior camera video unit 23 includes one or more charge-coupled device (CCD) cameras etc., and functions as a drive recorder that captures the inside and outside of the vehicle. The vehicle interior and exterior camera video unit 23 is further configured to, under the control of the processing unit 26, capture drive recorder video and transmit it as image data from the communication unit 28 via the communication network 10 to the server device 200 as appropriate.

The biometric data unit 24 detects biometric data of the driver or user directly or indirectly by, using for example, various vital sensors installed at predetermined positions in the vehicle 100, an image analysis device that analyzes the appearance of the driver or user, and a voice analysis device that analyzes the voice of the driver or user. The biometric data unit 24 is further configured to, under the control of the processing unit 26, transmit the detected biometric data from the communication unit 28 via the communication network 10 to the server device 200 as appropriate.

The processing unit 26 includes a central processing unit (CPU), a memory, etc. The CPU controls the interface unit 20, the vehicle behavior and driving operation (CAN) unit 21, the position information unit 22, the vehicle interior and exterior camera video unit 23, the biometric data unit 24, and the communication unit 28. The processing unit 26 transmits data related to the vehicle 100 and its driver, detected or generated by these units, from the communication unit 28 to the server device 200 as appropriate, as data in a predetermined format. The processing unit 26 is also configured to receive, via the communication unit 28, data indicating estimation results etc. from the server device 200 as appropriate.

The communication unit 28 includes, for example, a modem configured to communicate with the outside of the vehicle via the communication network 10. The communication unit 28 is configured to, under the control of the processing unit 26, transmit, as first-type input data, various raw data collected in the vehicle 100 to the server device 200 via the communication network 10 as appropriate.

In FIG. 1, the server device 200 includes a communication unit 201 and a processing unit 210.

The communication unit 201 is configured to, under the control of the processing unit 210, receive various data collected in the vehicle 100 via the communication network 10 as appropriate, and receive user data collected by the user data collection unit 306 via the communication network 10 and deliver the received data to the processing unit 210, as appropriate.

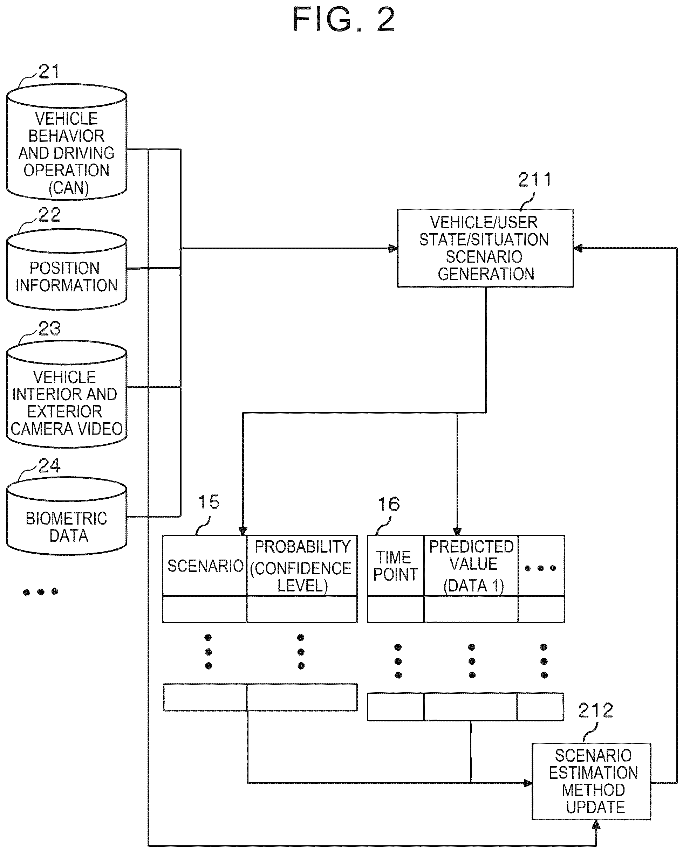

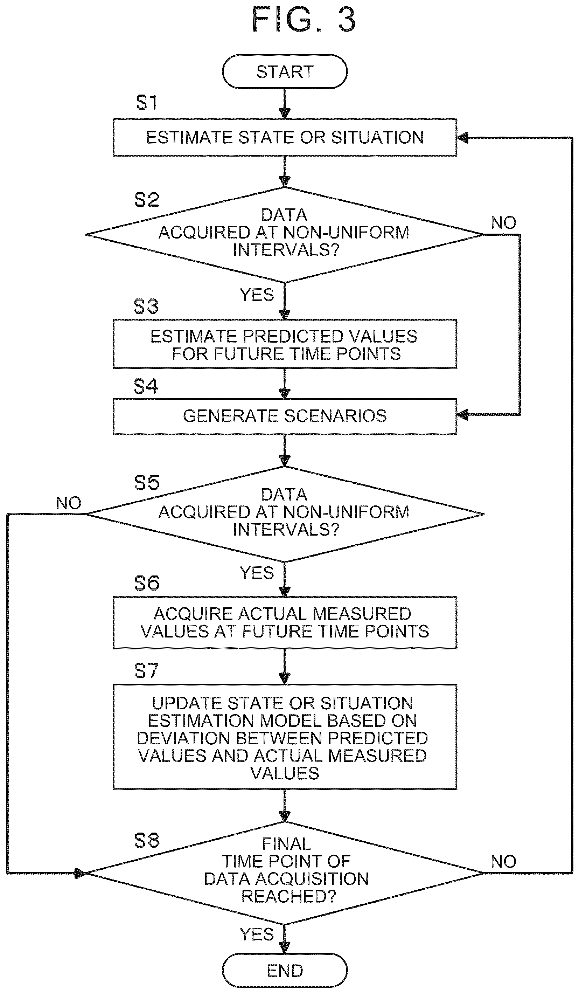

The processing unit 210 includes a vehicle/user state/situation scenario generation unit 211 (hereinafter simply referred to as "scenario generation unit 211") and a scenario estimation method update unit 212 (hereinafter simply referred to as "update unit 212"). Various processes executed by these units will be described in detail later with reference to FIGS. 2 and 3.

The DB 300 includes a large-scale, high-speed data input/output storage device that stores various types of data received by the server device 200 via the communication network 10, in particular various types of data to be used for estimation processing using machine learning, and data related to estimation results or intermediate progress generated by the processing unit 210.

Next, a scenario generation process and a scenario estimation method update process that are executed mainly by the processing unit 210 according to the present embodiment will be described with reference to the schematic conceptual diagram of FIG. 2 together with the block diagram of FIG. 1.

In FIG. 2, CAN data of the vehicle 100, position information indicating the current position (e.g., raw position information data indicating latitude and longitude or coordinates), raw video data, raw biometric data, etc. are input from the vehicle behavior and driving operation (CAN) unit 21, the position information unit 22, the vehicle interior and exterior camera video unit 23, and the biometric data unit 24 of the vehicle 100 to the scenario generation unit 211 in this order. The input here may be steady or periodic input. However, particularly in the present embodiment, even when input data is data acquired at non-uniform frequencies or non-uniform intervals, scenario generation can be carried out with high accuracy and efficiency by using machine learning.

The scenario generation unit 211 is an example of the "scenario estimation unit." The scenario generation unit 211 integrates, by machine learning such as single-modal LLM learning, multimodal LLM learning, other AI learning, or generative AI learning, a plurality of types of input data affecting the state or situation of the vehicle or user, as described above, to estimate a scenario of the state or situation. When at least one type of data among the input data is data acquired at non-uniform frequencies or intervals and not time-synchronized, the scenario generation unit 211 estimates a scenario for any given time point of the at least one type of data.

The scenario generation unit 211 is also an example of the "probability estimation unit." The scenario generation unit 211 estimates the probability (which may also be referred to as "confidence level") of the estimated scenario by, for example, machine learning. As a result, as shown in FIG. 2, tabular data 15 in which each estimated scenario is associated with its corresponding estimated probability is constructed by estimation using machine learning.

The scenario generation unit 211 is also an example of the "predicted value estimation unit." In parallel with or before or after the above-described scenario estimation processing and corresponding probability estimation processing, the scenario generation unit 211 estimates, for the at least one type of data, predicted value data that is not acquired at the time of scenario estimation, by using, for example, machine learning. As a result, as shown in FIG. 2, tabular data 16 in which predicted values are associated with respective time points is constructed by estimation using machine learning.

When the data 15, 16 are thus constructed, the update unit 212 update a model of the machine learning based on the estimated predicted value data, actual measured values corresponding to the estimated predicted value data among the input data, the estimated probabilities, and the input data.

Next, an example of processing in the scenario generation system according to the present embodiment (particularly processing executed by the processing unit 210 of the server device 200) will be described with reference to the flowchart of FIG. 3 together with the block diagram of FIG. 1 and the schematic conceptual diagram of FIG. 2.

In FIG. 3, the scenario generation unit 211, functioning as the "scenario estimation unit," estimates the state or situation of the vehicle or user (step S1). It is then determined whether the data input for estimation is data acquired at non-uniform intervals (step S2).

When it is determined in step S2 that the input data is data acquired at non-uniform intervals (step S2: Yes), the scenario generation unit 211, functioning as the "predicted value estimation unit," estimates predicted values for future time points (step S3). Tabular data 16 (see FIG. 2) is thus generated. Subsequently, the scenario generation unit 211, functioning as the "scenario estimation unit", generates a scenario using machine learning, after adding the estimated predicted values to the input data for machine learning. At this time, the scenario generation unit 211, functioning as the "probability estimation unit," estimates the probability of each estimated scenario. Tabular data 15 (see FIG. 2) is thus generated (step S4).

On the other hand, when it is determined in step S2 that the input data is not data acquired at non-uniform intervals (step S2: No), scenario generation is performed without going through step S3 (step S4). As a result of the scenario generation in step S4, tabular data 15 (see FIG. 2) is generated in which various scenarios, such as "the current location is the intersection in front of Tokyo Tower, with the Tokyo Tower visible on the right," "currently waiting at the traffic light at the intersection in front of Tokyo Tower," "user A is driving on the highway at 80 kph," and "user A is fatigued, and a rest at the next service area B is recommended," are associated with their respective probabilities.

Subsequently, the scenario generation unit 211 again determines whether the input data is data acquired at non-uniform intervals (step S5). When the input data is data acquired at non-uniform intervals (step S5: Yes), actual measured values at future time points are acquired from the vehicle behavior and driving operation (CAN) unit 21, the position information unit 22, the vehicle interior and exterior camera video unit 23, the biometric data unit 24, etc. (step S6).

Thereafter, based on the deviation between the predicted values in the data 16 estimated in step S3 and the actual measured values acquired in step S6, the update unit 212, functioning as the "machine learning model update unit," updates the machine learning model for state or situation estimation in the scenario generation unit 211 (step S7).

Subsequently, when the final time point of data acquisition has been reached (step S8: Yes), the series of processes relating to the scenario generation is terminated. Alternatively, as long as the final time point of data acquisition has not been reached (step S8: No), the series of processes from step S1 onward related to the scenario generation is repeatedly executed.

On the other hand, when it is determined in step S5 that the input data is not data acquired at non-uniform intervals (step S5: No), the process proceeds to step S8, where it is determined whether the final time point of data acquisition has been reached (step S8), and the series of processes is either repeatedly executed or terminated. Such a series of processes may be invoked periodically or non-periodically as needed as a subroutine that can be repeatedly executed in a short time.

As described in detail above, according to the present embodiment, a scenario integrating multiple states or situations in which the vehicle or user is placed can be generated even from the input data acquired at non-uniform frequencies or intervals.

For example, in the scenario generation unit 211 that performs various estimation processes, the scenarios may be converted at least partly into text by an LLM and then vectorized in order to efficiently execute the above-described machine learning. In each of the processes using the above-described machine learning, LLMs may be fine-tuned using large amounts of text data etc. As a result, the system can be adapted to various natural language processing (NLP) tasks such as text classification, sentiment analysis, information extraction, text summarization, text generation, and question answering.

In the present embodiment, the scenario generation unit 211 and the update unit 212 are represented as separate functional blocks that execute different processes. However, these units may be implemented as hardware by a single processor etc., or may be constructed in software so as to be treated as separate functional units.

In the scenario generation system according to the present embodiment, the scenario generation unit 211 and the update unit 212 may be configured to update autoregressive generative models such as multimodal LLMs, ChatGPT, or Transformers, and more broadly, existing or future improved autoregressive generative models or models. Alternatively, the scenario generation unit 211 and the update unit 212 may be configured to update a model that generates scenarios in text form after estimating individual states or situations with a time-series model. As examples of such models, state-space models, latent variable models, or time-series prediction models (e.g., conventional Kalman filters, particle filters, recurrent neural networks, LTSM, HiPPO, LSSL, S4, Mamba, etc.) may be used for estimation, and the high-dimensional output values or embedding vectors thereof may be input into an autoregressive generative model. In any of these cases, the effect of the present embodiment, namely that "a scenario can be generated even from input data acquired at non-uniform frequencies or intervals," is appropriately achieved.

### Appendices

The following appendices are further disclosed regarding the embodiment described above.

### Appendix 1

A scenario generation system according to Appendix 1 of the present invention is configured to generate a scenario of a state or situation of a vehicle or user. The scenario generation system includes: a scenario estimation unit configured to integrate, by machine learning, a plurality of types of input data affecting a state or situation of a vehicle or user, to estimate a scenario of the state or situation, and configured to, when at least one type of data among the input data is data acquired at non-uniform frequencies or intervals and not time-synchronized, estimate a scenario for any given time point of the at least one type of data; a probability estimation unit configured to estimate a probability of the estimated scenario; a predicted value estimation unit configured to estimate, for the at least one type of data, predicted value data that is not acquired at the time of scenario estimation; and a machine learning model update unit configured to update a model of the machine learning based on the estimated predicted value data, actual measured values corresponding to the estimated predicted value data among the input data, the estimated probabilities, and the input data.

In the scenario generation system according to Appendix 1, the scenario estimation unit integrates, by machine learning, a plurality of types of input data affecting a state or situation of a vehicle or user, to estimate a scenario of the state or situation. When at least one type of data among the input data is data acquired at non-uniform frequencies or intervals and not time-synchronized, the scenario estimation unit estimates a scenario for any given time point of the at least one type of data. The probability estimation unit then estimates the probability of the estimated scenario. In parallel with or before or after this, the predicted value estimation unit estimates, for the at least one type of data, predicted value data that is not acquired at the time of scenario estimation. The machine learning model update unit then updates a model of the machine learning based on the estimated predicted value data, actual measured values corresponding to the estimated predicted value data among the input data, the estimated probabilities, and the input data. Accordingly, a scenario integrating multiple states or situations in which the vehicle or user is placed can be generated even from input data acquired at non-uniform frequencies or intervals.

### Appendix 2

A scenario generation system according to Appendix 2 of the present invention is the scenario generation system according to Appendix 1 in which the input data includes vehicle behavior and driving operation data including CAN data, position information data, vehicle interior and exterior camera video data, and biometric data, all related to the vehicle or user.

In the scenario generation system according to Appendix 2 of the present invention, the scenario estimation unit estimates a scenario based on vehicle behavior and driving operation data, position information data, vehicle interior and exterior camera video data, and biometric data, and uses this to update the model of the machine learning. Accordingly, a scenario integrating multiple states or situations in which the vehicle or user is placed can be generated even when these pieces of data are input data acquired at non-uniform frequencies or intervals.

### Appendix 3

A scenario generation system according to Appendix 3 of the present invention is the scenario generation system according to Appendix 1 or 2 in which the scenario estimation unit is configured to estimate each of the scenarios as a single sentence, or to estimate each of the scenarios by predefined items in addition to or in place of estimating each of the scenarios as a single sentence.

In the scenario generation system according to Appendix 3 of the present invention, the scenario estimation unit estimates each of the scenarios as a single sentence using machine learning such as an LLM or a multimodal LLM, or estimates each of the scenarios by the predefined items in addition to or in place of estimating each of the scenarios as a single sentence. A scenario is thus estimated as a sentence. In other words, a scenario is estimated by generating textural or verbalized data from non-textural or non-verbal data. Accordingly, by including, as grounds for estimation, textual content of general knowledge, general conventions, papers, related literature, etc. associated with textual or verbalized data generated by an LLM or a multimodal LLM, it becomes possible to improve the accuracy and efficiency of the estimation processing. In addition to or instead of this, by estimating a scenario by predefined items, the accuracy and efficiency of the estimation processing can also be appropriately improved compared to performing machine learning indiscriminately without any definitions.

### Appendix 4

A scenario generation system according to Appendix 4 of the present invention is the scenario generation system according to any one of Appendices 1 to 3 in which the predicted value estimation unit is configured to use missing value imputation or time-series prediction to estimate the predicted value data that is not acquired at the time of scenario estimation.

In the scenario generation system according to Appendix 4 of the present invention, since the predicted value estimation unit uses existing or future improved methods of missing value imputation or time-series prediction, it is possible to estimate the predicted value data with high accuracy and efficiency.

### Appendix 5

A scenario generation method according to Appendix 5 of the present invention includes: integrating, by machine learning, a plurality of types of input data affecting a state or situation of a vehicle or user, to estimate a scenario of the state or situation, and, when at least one type of data among the input data is data acquired at non-uniform frequencies or intervals and not time-synchronized, estimating a scenario for any given time point of the at least one type of data; estimating a probability of the estimated scenario; estimating, for the at least one type of data, predicted value data that is not acquired at the time of scenario estimation; and updating a model of the machine learning based on the estimated predicted value data, actual measured values corresponding to the estimated predicted value data among the input data, the estimated probabilities, and the input data.

In the scenario generation method according to Appendix 5 of the present invention, as in the scenario generation system according to Appendix 1, a scenario integrating multiple states or situations in which the vehicle or user is placed can be generated even from input data acquired at non-uniform frequencies or intervals.

The present invention can be modified as appropriate within the scope not departing from the gist or spirit of the invention as read from the claims and the entire specification, and a scenario generation system and method involving such modifications are also included in the technical idea of the present invention.

## Claims

1. A scenario generation system configured to generate a scenario of a state or situation of a vehicle or user, the scenario generation system comprising:
a scenario estimation unit configured to integrate, by machine learning, a plurality of types of input data affecting a state or situation of a vehicle or user, to estimate a scenario of the state or situation, and configured to, when at least one type of data among the input data is data acquired at non-uniform frequencies or intervals and not time-synchronized, estimate a scenario for any given time point of the at least one type of data;
a probability estimation unit configured to estimate a probability of the estimated scenario;
a predicted value estimation unit configured to estimate, for the at least one type of data, predicted value data that is not acquired at a time of scenario estimation; and
a machine learning model update unit configured to update a model of the machine learning based on the estimated predicted value data, actual measured values corresponding to the estimated predicted value data among the input data, the estimated probabilities, and the input data.

2. The scenario generation system according to claim 1, wherein the input data includes vehicle behavior and driving operation data including Controller Area Network data, position information data, vehicle interior and exterior camera video data, and biometric data, all related to the vehicle or user.

3. The scenario generation system according to claim 1 or 2, wherein the scenario estimation unit is configured to estimate each of the scenarios as a single sentence, or to estimate each of the scenarios by predefined items in addition to or in place of estimating each of the scenarios as a single sentence.

4. The scenario generation system according to any one of claims 1 to 3, wherein the predicted value estimation unit is configured to use missing value imputation or time-series prediction to estimate the predicted value data that is not acquired at the time of scenario estimation.

5. A method for generating a scenario of a state or situation in which a vehicle or user is placed, the method comprising:
integrating, by machine learning, a plurality of types of input data affecting a state or situation of a vehicle or user, to estimate a scenario of the state or situation, and, when at least one type of data among the input data is data acquired at non-uniform frequencies or intervals and not time-synchronized, estimating a scenario for any given time point of the at least one type of data;
estimating a probability of the estimated scenario;
estimating, for the at least one type of data, predicted value data that is not acquired at a time of scenario estimation; and
updating a model of the machine learning based on the estimated predicted value data, actual measured values corresponding to the estimated predicted value data among the input data, the estimated probabilities, and the input data.
